# FASCICULE DE BREVET EUROPEEN

(11) **EP 2 509 227 B1**
(45) Date de publication et mention de la délivrance du brevet: **12.04.2017**
(21) Numéro de dépôt: 12161983.7
(22) Date de dépôt: 29.03.2012
(51) Int. Cl.: H03H 7/40, H04B 1/04, H04B 1/18

(54) **PROCEDE D'ADAPTATION AUTOMATIQUE D'IMPEDANCE DE CIRCUIT RADIOFREQUENCE ET CHAÎNE D'EMISSION OU RECEPTION MODULAIRE**
VERFAHREN ZUR AUTOMATISCHEN IMPEDANZANPASSUNG EINER RADIOFREQUENZSCHALTUNG, UND MODULARE FUNKEMISSIONS- ODER EMPFANGSKETTE
METHOD FOR AUTOMATIC IMPEDANCE MATCHING OF A RADIO-FREQUENCY CIRCUIT AND MODULAR TRANSMISSION OR RECEPTION CHANNEL

(30) Priorité: 07.04.2011 FR 1153035
(43) Date de publication de la demande: 10.10.2012
(73) Titulaire: Commissariat à l'Énergie Atomique et aux Énergies Alternatives, 75015 Paris (FR)
(72) Inventeur: De Foucauld, Emeric, 38500 VOIRON (FR); David, Jean-Baptiste, 38000 GRENOBLE (FR); El Kaamouchi, Majid, 94440 VILLECRESNES (FR)
(74) Mandataire: Bréda, Jean-Marc

(56) Documents cités:
- US-A- 5 589 844
- US-A1- 2008 081 581
- US-A1- 2009 066 440
- US-A1- 2011 053 524

## Description

L'invention concerne la réalisation d'un circuit d'adaptation automatique d'impédance d'antenne radiofréquence.

Dans certaines applications de transmission d'informations en radiofréquence, on a constaté que l'antenne d'émission ou de réception pouvait avoir une impédance dépendant fortement de conditions extérieures à l'antenne, et dépendant notamment du milieu dans lequel l'antenne est placée.

Par exemple, dans la télémétrie médicale, on peut être amené à introduire l'antenne dans une sonde placée dans le corps humain, et l'impédance dépend alors fortement du milieu biologique dans lequel l'antenne se trouve. Elle dépend des propriétés électriques (conductivité, constante diélectrique) des tissus environnants (muscles, graisse) ou du milieu liquide (sang, autres liquides) dans lequel l'antenne peut être immergée.

Même dans des applications plus conventionnelles de transmission radiofréquence (téléphonie mobile, etc.) l'impédance de l'antenne peut varier en fonction de l'environnement dans lequel se trouve l'utilisateur.

Une chaîne d'émission (ou respectivement de réception) comprend au moins un amplificateur auquel peuvent être associés un ou plusieurs filtres et une antenne (en sortie de l'amplificateur pour une chaîne d'émission, en entrée de l'amplificateur pour une chaîne de réception).

De manière générale, les variations d'impédance d'antenne sont particulièrement sensibles pour des antennes de très petites dimensions ayant un fort coefficient de qualité, utilisées dans les applications à fortes contraintes de miniaturisation.

Ces variations d'impédance peuvent entraîner des pertes dites pertes de désadaptation : ces pertes résultent de ce que la chaîne d'émission qui alimente l'antenne, ou la chaîne de réception qui reçoit un signal de l'antenne, est en général conçue pour avoir des performances optimales lorsqu'elle est chargée (en sortie pour la chaîne d'émission ou en entrée pour la chaîne de réception) par une impédance nominale bien déterminée ; elle a des performances dégradées lorsqu'elle est chargée par une impédance différente de sa valeur nominale. Les pertes de désadaptation peuvent aller jusqu'à 40 dB.

C'est pourquoi on a déjà essayé d'interposer entre la sortie de l'amplificateur et l'antenne d'émission (et on pourrait le faire aussi en entrée pour une antenne de réception) un réseau d'adaptation d'impédance, en anglais « matching network », qui fait que l'amplificateur voit une impédance différente de celle de l'antenne et de préférence égale à la valeur nominale pour laquelle il a été conçu, par exemple 100 ohms ou 500 ohms. Le réseau d'adaptation est accordable, c'est-à-dire que ses éléments, capacitifs et/ou inductifs, ont des valeurs ajustables pour tenir compte des conditions d'environnement de l'antenne de telle sorte que l'adaptation soit la meilleure possible quelles que soient les circonstances.

Dans la demande de brevet US 2009-0066440, on a proposé un procédé d'adaptation automatique d'impédance dans une chaîne d'émission ou de réception, dans lequel on détecte à la fois l'amplitude et la phase du courant et de la tension en sortie de la chaîne d'émission (ou en entrée de la chaîne de réception). Le rapport entre la tension et le courant est représentatif de l'impédance de charge Zm vue par la chaîne chargée par l'ensemble du réseau d'adaptation et de l'antenne d'impédance Zₐₙₜ. On mesure l'impédance de charge Zm et on calcule l'impédance d'antenne Zₐₙₜ à partir de l'impédance de charge mesurée Zm et des impédances du réseau d'adaptation dont la configuration est connue au moment de la mesure, et enfin on calcule la modification qu'il faut appliquer à une ou plusieurs des impédances du réseau d'adaptation, pour obtenir que l'impédance vue par l'amplificateur devienne adaptée à l'impédance nominale de l'amplificateur dans les conditions actuelles d'environnement de l'antenne.

Ce procédé d'adaptation a l'avantage considérable, par rapport à des procédés plus anciens, de permettre une adaptation sans calcul itératif. Une seule mesure suffit pour effectuer l'adaptation. Mais il nécessite une circuiterie et des moyens de calcul importants. Cette circuiterie et ces moyens de calcul s'avèrent coûteux et encombrants, alors que dans un certain nombre d'applications il n'est pas nécessaire de s'en servir plus d'une fois ou de quelques fois.

On notera enfin que la publication de brevet US 2011/0053524 décrit des procédés de calibration de dispositifs de communication, utilisant un ordinateur et une chambre anéchoïde, et que la publication de brevet US5589844 décrit des procédés de calibration utilisant une connexion amovible à un pont de Wheatstone pour renvoyer une mesure du degré d'adaptation à un dispositif de commande.

L'invention a pour but de réduire le coût de la mise en oeuvre industrielle des procédés d'adaptation automatique d'impédance dans les chaînes d'émission et de réception qui nécessitent de manière peu fréquente une telle opération d'adaptation.

Selon l'invention, on propose un procédé d'adaptation d'impédance d'une chaîne d'émission ou de réception comprenant les étapes suivantes : - connecter de manière amovible un premier module de la chaîne, contenant un amplificateur, à un deuxième module contenant des moyens de calcul d'adaptation d'impédance ; - connecter de manière amovible un troisième module au deuxième module, alors que le deuxième module est connecté au premier, le troisième module contenant une antenne, un réseau d'impédances d'adaptation, et des moyens de mémorisation de données de commande du réseau d'impédances, - effectuer un calcul d'adaptation dans le deuxième module pendant qu'il est ainsi connecté de manière amovible entre le premier et le troisième module, et fournir par le deuxième module au troisième module des données de commande du réseau d'adaptation, résultant de ce calcul, - mémoriser les données de commande dans les moyens de mémorisation du troisième module, - enlever le deuxième module et connecter de manière amovible le troisième module au premier module de manière à relier l'amplificateur à l'antenne à travers le réseau d'adaptation, ce dernier étant alors commandé par les données de commande mémorisées.

Ainsi, la chaîne d'émission ou de réception fonctionne normalement avec le premier module connecté directement au troisième module. C'est seulement pour une opération ponctuelle d'adaptation d'impédance qu'on vient interposer le deuxième module entre le premier et le troisième. Un deuxième module unique peut être utilisé à tour de rôle pour des dizaines ou des centaines de premiers et troisièmes modules lorsqu'il faut effectuer l'adaptation d'impédance désirée, la chaîne ne comportant que deux modules en dehors des opérations de réglage de l'adaptation.

Pour mettre en oeuvre ce procédé, l'invention propose une chaîne d'émission ou de réception radiofréquence comportant au moins un amplificateur, une antenne et un réseau d'impédances d'adaptation disposé entre l'amplificateur et l'antenne, cette chaîne étant caractérisée en ce qu'elle comprend un module d'amplification et un module d'antenne, le module d'amplification contenant l'amplificateur et au moins un premier connecteur pour une connexion amovible au module d'antenne, le module d'antenne contenant l'antenne, le réseau d'impédances d'adaptation, au moins un premier connecteur coopérant avec le premier connecteur du module d'amplification pour transmettre des signaux radiofréquence du module d'amplification vers le module d'antenne, des moyens de mémorisation permanente de données de commande permettant une commande des impédances du réseau pour donner à ces impédances des valeurs désirées, et au moins un deuxième connecteur permettant une connexion amovible avec l'extérieur du module d'antenne pour recevoir de l'extérieur des données de commande à mémoriser.

Le module d'amplification comporte aussi un connecteur (de préférence un autre connecteur mais exceptionnellement le même connecteur) connecté de manière amovible à un connecteur du module d'antenne pour une alimentation électrique du module d'antenne par le module d'amplification. Ceci seulement dans le cas où le module d'antenne nécessite une alimentation électrique pour son fonctionnement. On reviendra plus loin sur ce point.

Lors d'une opération d'adaptation d'impédance, cette configuration de chaîne est modifiée par l'insertion d'un module de calcul d'adaptation d'impédance entre le module d'amplification et le module d'antenne. Le module de calcul d'adaptation d'impédance comporte à cet effet :
- un premier connecteur connecté de manière amovible au premier connecteur du module d'amplification pour la transmission de signaux radiofréquence du module d'amplification au module de calcul,
- un deuxième connecteur connecté de manière amovible au premier connecteur du module d'antenne, pour la transmission de signaux radiofréquence du module de calcul au module d'antenne,
- un troisième connecteur connecté de manière amovible au deuxième connecteur du module d'antenne,
- des moyens pour calculer des valeurs d'impédances d'adaptation en fonction de l'impédance de l'antenne et pour fournir des données de commande correspondantes aux moyens de mémorisation à travers le troisième connecteur du module de calcul et le deuxième connecteur du module d'antenne.

Le module d'amplification comporte aussi un connecteur (de préférence un deuxième connecteur mais exceptionnellement le même connecteur) pour la connexion amovible à un connecteur du module de calcul pour fournir une alimentation électrique à ce dernier. Il comporte aussi de préférence un connecteur pour la connexion amovible à un connecteur du module d'antenne, pour fournir une alimentation électrique à ce dernier. Le connecteur du module d'antenne pour son alimentation électrique est de préférence connectable directement au connecteur correspondant du module d'amplification, pour l'alimentation électrique directe du module d'antenne par le module d'amplification.

Par conséquent, le premier connecteur du module d'antenne est de préférence identique au premier connecteur du module de calcul ; de même, le premier connecteur du module d'amplification est de préférence identique au deuxième connecteur du module de calcul.

La mémorisation des données calculées peut être faite par des commutateurs à actionnement magnétique et à maintien magnétique, qui ne nécessitent aucune source d'énergie pour la conservation et l'utilisation des données. Elle peut être faite aussi par des fusibles (mais n'est alors réalisable qu'une fois), ou encore par une mémoire permanente reprogrammable (EEPROM) ; dans ce dernier cas, il est nécessaire que le troisième module dispose d'une alimentation électrique pour que les informations de la mémoire être extraites de celle-ci et appliquées comme données de commande au réseau d'adaptation. Cette alimentation peut être fournie par le premier module lorsqu'il est connecté directement au troisième, mais on peut aussi prévoir que le troisième module soit pourvu d'une alimentation autonome, pile ou batterie.

Le réseau d'adaptation peut être constitué d'un montage simple à trois impédances réactives en Té ou en Pi, par exemple une capacité et deux inductances ou mieux une inductance et deux capacités. Au moins une de ces impédances est variable mais en pratique deux des impédances seront variables. De préférence on utilisera deux capacités variables et une inductance fixe en considérant qu'il est plus facile de réaliser des capacités variables précises que des inductances variables. Les impédances variables sont de préférence réalisées sous forme de plusieurs impédances élémentaires en série et/ou en parallèle, individuellement commutables par une commande électronique.

D'autres caractéristiques et avantages de l'invention apparaîtront à la lecture de la description détaillée qui suit et qui est faite en référence aux dessins annexés dans lesquels :
- la figure 1 représente la constitution générale d'un circuit d'émission radiofréquence comportant des moyens d'adaptation automatique d'impédance ;
- la figure 2 représente les modules d'une chaîne d'émission radiofréquence selon l'invention ;
- la figure 3 représente une chaîne d'émission selon l'invention dans sa configuration permettant une adaptation automatique d'impédance ;
- la figure 4 représente une chaîne d'émission selon l'invention dans une configuration de fonctionnement normal où l'impédance du module d'antenne a été préalablement adaptée à l'impédance de l'amplificateur ;
- la figure 5 représente un exemple de réseau d'impédances d'adaptation.

Dans la description détaillée qui suit, on considérera systématiquement que l'antenne est une antenne d'émission alimentée par la sortie d'un amplificateur. L'amplificateur est conçu pour fonctionner de manière optimale lorsque la charge placée à sa sortie a une impédance nominale Zₒₚₜ et lorsque la fréquence de fonctionnement est f, correspondant à une pulsation ω = 2π.f. A haute fréquence, l'impédance Zₒₚₜ sera généralement complexe. L'invention est applicable de la même manière si l'antenne est une antenne de réception connectée à l'entrée d'un amplificateur conçu pour fonctionner de manière optimale lorsque l'impédance connectée à son entrée est une impédance nominale Zₒₚₜ et lorsque la fréquence de fonctionnement est f.

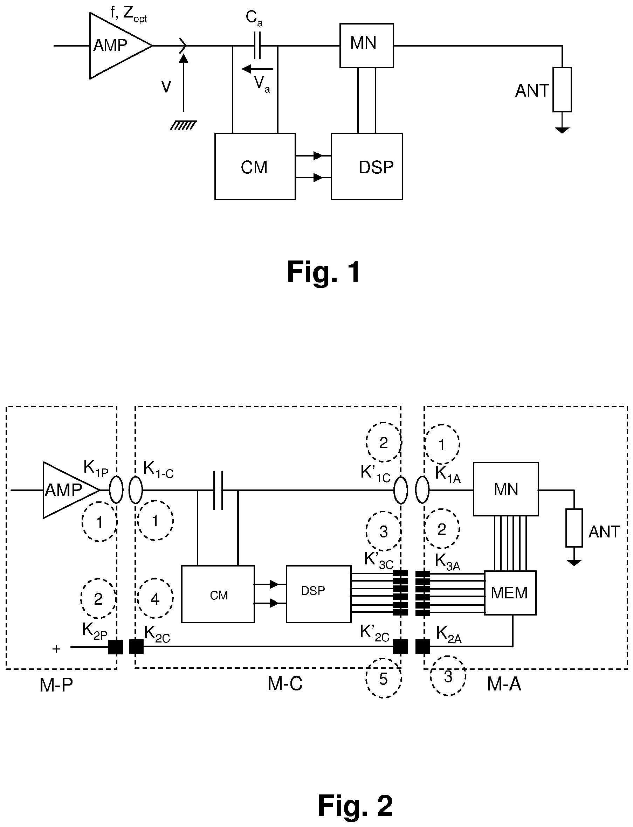

La figure 1 représente un schéma de principe de circuit d'émission radiofréquence, avec un amplificateur AMP travaillant à la fréquence porteuse d'émission f, une antenne ANT alimentée par l'amplificateur, un réseau d'adaptation MN inséré en série entre la sortie de l'amplificateur AMP et l'antenne ANT. Ce schéma pourrait aussi inclure un filtre entre l'amplificateur AMP et le réseau MN et/ou un filtre entre le réseau MN et l'antenne.

Le réseau d'adaptation MN est inclus dans un circuit d'adaptation automatique d'impédance dont la fonction est de faire en sorte que l'impédance de la charge de l'amplificateur soit égale à l'impédance optimale Zₒₚₜ de l'amplificateur ou la plus proche possible de cette impédance optimale. La charge de l'amplificateur est essentiellement constituée par le réseau MN lui-même chargé par l'antenne ANT.

Outre le réseau MN, le circuit d'adaptation comprend :
- une impédance de mesure placée en série entre la sortie de l'amplificateur et le réseau d'adaptation MN ; elle sert à la mesure du courant i qui sort de l'amplificateur ; cette impédance est de préférence une simple capacité Cₐ d'impédance 1/j.Cₐ.ω ; la tension à ses bornes est une tension vₐ = i/j.Cₐ.ω ; le courant est i = j.vₐ.Cₐ.ω ;
- un circuit de mesure CM de la tension vₐ aux bornes de l'impédance de mesure et de la tension V en sortie de l'amplificateur (ou en entrée du réseau d'adaptation chargé par l'antenne) en valeurs complexes, c'est-à-dire en incluant la valeur du déphasage entre ces tensions ;
- des moyens de calcul DSP qui permettent de calculer mathématiquement, à partir de ces valeurs complexes vₐ et V, quelles valeurs d'impédances il faut donner aux impédances du réseau d'adaptation MN pour réaliser une adaptation entre l'impédance de sortie de l'amplificateur et l'impédance de la charge appliquée à cette sortie.

Les moyens de calcul DSP fournissent, directement ou par l'intermédiaire d'un circuit logique de commande, des signaux de commande de commutateurs non représentés qui font partie du réseau MN et qui établissent les valeurs d'impédances désirées pour chaque impédance de ce réseau.

La publication de brevet US2009-0066440 décrit la manière dont fonctionne le circuit d'adaptation. En résumé, les moyens de calcul DSP calculent le module et l'argument de l'impédance Zm = V/i de la charge actuelle de l'amplificateur à partir de la tension V et du courant i, ce dernier étant obtenu à partir de la tension Vₐ ; ils calculent à partir de là l'impédance vectorielle Zm en partie réelle et partie imaginaire ; ils calculent l'impédance effective de l'antenne Zₐₙₜ à partir de ces valeurs et des valeurs d'impédance actuelles connues des différentes impédances Z1, Z2, etc. qui constituent le réseau d'adaptation MN ; ils calculent une ou plusieurs valeurs d'impédances modifiées Z'1, Z'2 du réseau d'adaptation MN à partir d'une valeur désirée Zₒₚₜ de l'impédance de charge de l'amplificateur et à partir de l'impédance d'antenne calculée Zₐₙₜ, et enfin ils fournissent au réseau MN les signaux de commande appropriés pour donner aux impédances Z1, Z2, etc. de ce réseau les valeurs modifiées Z'1, Z'2, etc. ainsi calculées. La chaîne d'émission et de réception est adaptée lorsque les impédances du réseau d'adaptation prennent ces valeurs calculées Z'1, Z'2, etc.

Selon l'invention on prévoit de constituer la chaîne d'émission (ou de réception) selon deux configurations possibles, utilisant trois modules connectables entre eux de manière amovible. Ces modules sont respectivement un module d'amplification (comprenant selon le cas un amplificateur d'émission ou un amplificateur de réception), un module de calcul d'adaptation, et un module d'antenne comprenant une antenne et un réseau d'impédances d'adaptation. Ces modules sont pourvus de connecteurs permettant de connecter de manière amovible le module d'amplification au module d'antenne
- soit avec interposition du module de calcul d'adaptation entre le module d'antenne et le module d'amplification, lors d'une opération d'adaptation d'impédance,
- soit directement après l'opération d'adaptation.

Les connecteurs et connexions auxquelles il est fait référence dans cette description sont des connecteurs et connexions électriques directes, par contact.

La figure 2 représente les trois modules possibles de cette chaîne, qui est ici une chaîne d'émission. Les modules seraient les mêmes pour une chaîne de réception, mais le module d'amplification serait relié aux autres modules du côté de l'entrée de l'amplificateur et non de la sortie.

Le module d'amplification M-P contient des circuits de production du signal radiofréquence qu'on veut émettre à partir de l'antenne, et en particulier à la sortie du module un amplificateur de puissance fonctionnant en radiofréquence. Seul l'amplificateur en sortie du module est représenté.

Le module d'antenne M-A comporte non seulement une antenne ANT mais aussi un réseau d'impédances d'adaptation MN, commandable électriquement, associé à un dispositif de mémorisation MEM. Le dispositif de mémorisation stocke les données de commande du réseau d'impédances, c'est-à-dire des données qui, lorsqu'elles sont appliquées au réseau MN, imposent aux impédances du réseau des valeurs bien définies (celles qui ont été déterminées par le module de calcul d'adaptation dans une phase de calcul d'adaptation).

De préférence, le réseau d'adaptation MN comprend des impédances commandables par des signaux logiques et le dispositif de mémorisation est une mémoire de signaux logiques. Par exemple, la mémoire stocke des informations binaires servant à commander des commutateurs faisant partie du réseau MN, ces interrupteurs agissant sur la valeur des éléments d'impédances auxquels ils sont associés. Par exemple un commutateur connecte un élément capacitif en parallèle sur d'autres éléments capacitifs pour modifier la valeur de l'ensemble de capacités en parallèle.

La mémoire MEM peut être une mémoire permanente, stockant une information définitive, ou une mémoire reprogrammable. Elle peut être constituée dans le premier cas par exemple par des fusibles. Dans le second cas elle peut être une mémoire de type EEPROM et dans ce cas il faut prévoir une alimentation électrique de cette mémoire aussi bien lors de sa programmation que lors de son utilisation en lecture. La mémoire peut aussi être constituée par un ensemble d'éléments (commutateurs) à actionnement magnétique et à maintien magnétique, et dans ce cas il n'est pas nécessaire de prévoir une alimentation électrique pour son utilisation, ni pendant la phase de calcul d'adaptation ni pendant la phase de fonctionnement de la chaîne.

Le module de calcul d'adaptation M-C comporte les éléments qui sont nécessaires au calcul des valeurs d'impédances qu'il faut donner au réseau MN pour réaliser l'adaptation d'impédance. Il comporte donc essentiellement, dans le cas où le calcul est fait comme indiqué ci-dessus, l'impédance de mesure Cₐ, le circuit de mesure CM qui mesure les tensions aux bornes de l'impédance de mesure et en sortie de l'amplificateur (ou en entrée du module d'antenne) et qui les convertit en valeurs numériques, et le processeur numérique DSP qui effectue les calculs et qui produit des signaux de commande à destination du dispositif de mémorisation MEM pour donner aux impédances du réseau les valeurs calculées.

Le module d'amplification M-P comporte deux connecteurs K_{1P} et et K2P destinés à être connectés au module de calcul d'adaptation M-C. Le module de calcul d'adaptation M-C comporte donc deux connecteurs correspondants K1 C et K2C qui coopèrent avec les connecteurs K1 P et K2P respectivement pour établir la connexion recherchée.

Les numéros dans les cercles pointillés des figures représentent les numéros des connecteurs de chaque module, le premier connecteur d'un module portant le numéro 1, le deuxième portant le numéro 2, etc.

Les connecteurs K1P et K1C sont des connecteurs radiofréquence, par exemple des connecteurs coaxiaux.

Les connecteurs K2P, K2C sont des connecteurs d'alimentation destinés à transmettre depuis le module d'amplification M-P jusqu'au module de calcul d'adaptation M-C l'énergie nécessaire au fonctionnement de ce dernier (par exemple une tension d'alimentation continue d'environ 3 volts, 5 volts ou 12 volts).

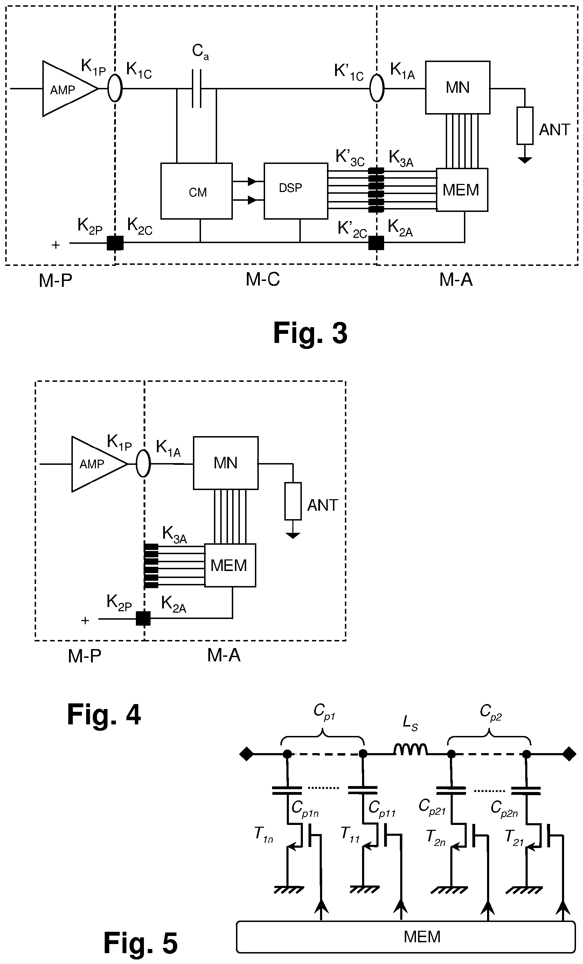

Le module M-C comporte également au moins deux connecteurs K'1C et K'2C pour la connexion avec le module d'antenne M-A. Le module d'antenne M-A comporte donc deux connecteurs correspondants K_{1A} et K_{2A} qui coopèrent avec les connecteurs K'_{1C} et K'_{2C} pour établir la connexion entre les modules M-C et M-A. De plus, les connecteurs K_{1A} et K_{2A} sont aptes à coopérer directement avec les connecteurs K_{1P} et K_{2P} pour établir une liaison directe, comme représenté sur la figure 4, entre le module d'amplification et le module d'antenne lorsque le module de calcul d'adaptation est supprimé. Les connecteurs K'_{1C} et K_{1A} sont donc des connecteurs radiofréquence, par exemple des connecteurs coaxiaux. Les connecteurs K'_{2C} et K_{2A} sont des connecteurs d'alimentation.

En pratique, le connecteur K'_{1C} est identique au connecteur K_{1P} puisque tous deux doivent s'adapter au connecteur K_{1A} ; et, de même, le connecteur K'_{2C} est identique au connecteur K_{2P} puisque tous deux doivent pouvoir s'adapter au connecteur K_{2A}.

Les connecteurs d'alimentation K'_{2C} et K_{2A} sont toutefois facultatifs ; ils sont présents si le module d'antenne nécessite une alimentation extérieure pour fonctionner, et en particulier si le dispositif de mémorisation MEM nécessite une alimentation pour fournir au réseau d'adaptation les données mémorisées mais n'a pas d'alimentation autonome. Mais si le dispositif d'alimentation MEM a une alimentation autonome (pile ou batterie) ou s'il ne nécessite pas d'alimentation pour fonctionner, ni en écriture ni en lecture, les connecteurs K'_{2C} et K_{2A} ne sont pas nécessaires.

Enfin, le module de calcul d'adaptation comporte un connecteur K'_{3C} pour la transmission des données de commande à mémoriser dans le dispositif de mémorisation MEM. Le connecteur est de préférence un connecteur adapté à transmettre des signaux logiques, les données de commande du réseau d'impédances d'adaptation étant de préférence transmises sous forme binaire. Le connecteur K'_{3C} peut être un connecteur multiple pour une transmission de signaux logiques en parallèle, ou un connecteur simple si les signaux de données sont transmis en série.

Le module d'antenne M-A comporte un connecteur multiple ou simple K_{3A} coopérant avec le connecteur K'_{3C} pour recevoir les signaux transmis par ce dernier et pour les transmettre au dispositif de mémorisation MEM.

On n'a pas représenté explicitement sur la figure 2 des connexions de masse permettant d'établir un potentiel de masse commun pour les trois modules ; cette connexion fait en général partie des connecteurs d'alimentation ou des connecteurs coaxiaux, ou même des connecteurs de signaux logiques.

Par ailleurs, dans toute cette description on a fait la distinction sur les figures entre les connecteurs d'alimentation et les connecteurs de signaux radiofréquence, mais il peut arriver que ces connecteurs soient confondus, car dans certains cas un même connecteur peut transmettre à la fois un signal radiofréquence et une tension continue d'alimentation superposée au signal radiofréquence. Dans la suite on suppose, pour simplifier les explications, que les connecteurs de signaux radiofréquence sont séparés des connecteurs d'alimentation conformément à la représentation de la figure 2.

La figure 3 représente la chaîne d'émission selon l'invention dans sa configuration à trois modules, configuration qui est utilisée au moment où on cherche à faire un calcul d'adaptation d'impédances.

Les connecteurs K_{1P} et K_{2P} du module d'amplification sont engagés dans les connecteurs K_{1C} et K_{2C} du module de calcul. Les connecteurs K'_{1C}, K'_{2C} (si ce dernier existe), K'_{3C} du module de calcul sont engagés dans les connecteurs K_{1A}, K_{2A} (si ce dernier existe), K_{3A} du module d'antenne.

Le circuit de mesure CM mesure les potentiels (complexes, tenant compte de la différence de phase) aux bornes de la capacité de mesure Cₐ et les convertit en numérique. La fréquence des signaux mesurés peut être la fréquence de travail normale de la chaîne ou une fréquence dédiée spécialement au calcul d'impédance. Dans les deux cas, le circuit de mesure peut comporter des circuits de changement de fréquence permettant une mesure à fréquence plus basse que la fréquence de travail.

Les valeurs numériques recueillies permettent de calculer l'impédance Zm de la charge connectée à l'amplificateur AMP. Cette charge est constituée par l'impédance de mesure (la capacité Cₐ) en série avec l'impédance du module d'antenne, cette dernière impédance étant celle de l'ensemble du réseau d'adaptation chargé par l'antenne.

A partir de l'impédance complexe Zm on sait calculer l'impédance de l'antenne Zₐₙₜ en partie réelle et imaginaire, connaissant l'impédance actuelle du réseau d'adaptation. Cette dernière est liée de manière biunivoque aux données de commande stockées dans le dispositif de mémorisation. Ces données sont mises en mémoire par le processeur de calcul DSP et sont donc connues de ce processeur. On peut imaginer par exemple que le calcul commence par une mise en mémoire de données de commande initiales prédéterminées.

Connaissant l'impédance actuelle Zₐₙₜ de l'antenne on sait calculer quelles impédances il faut mettre dans le réseau d'adaptation MN pour que l'ensemble en série du réseau MN et de l'antenne ANT ait une impédance globale optimale Zₒₚₜ en tant que charge de l'amplificateur. C'est la structure de l'amplificateur qui détermine quelle est cette impédance optimale. Le calcul prend en compte l'impédance de la capacité de mesure Cₐ. Le processeur DSP calcule les valeurs d'impédances nécessaires et les transmet sous forme de données de commande (de préférence binaires) sur le connecteur K'_{3C}. Ces données sont mises en mémoire permanente dans le dispositif de mémorisation MEM et modifient les impédances du réseau d'adaptation en conséquence.

Cette détermination d'impédance étant faite et le résultat étant mémorisé dans le module d'antenne, on peut enlever le module de calcul M-C.

La chaîne d'émission prend alors sa configuration de fonctionnement normale, qui est représentée à la figure 4. Le module d'antenne M-A est directement connecté au module d'amplification M-P à travers les connecteurs radiofréquence K_{1A} et K_{1P}.

Les connecteurs K_{2P} et K_{2A}, s'ils existent, sont également engagés, dans le cas où le dispositif de mémorisation a besoin d'une alimentation électrique pour commander le réseau d'adaptation MN.

Le connecteur K_{3A} n'est pas relié à un connecteur du module d'amplification dans cette configuration de chaîne.

L'impédance du réseau MN chargé par l'antenne a la valeur optimale Zₒₚₜ car les données mémorisées dans le dispositif de mémorisation MEM imposent aux impédances du réseau les valeurs qui aboutissent à ce résultat.

On notera que les connecteurs d'alimentation facultatifs K'_{2C} et K_{2A} peuvent être des broches spécifiques d'alimentation (et de masse) incorporées aux connecteurs K'_{3C} et K_{3A}.

La figure 5 représente un exemple de réseau d'impédances d'adaptation pouvant être commandé par une mémoire EEPROM. Le réseau est un réseau en Pi avec une inductance en série Lₛ entre deux capacités Cₚ₁ et Cₚ₂ en parallèle. La capacité Cₚ₁ est constituée chacune par plusieurs capacités en parallèle, Cp₁₁, Cp_{12 ....,} Cₚ₁ₙ, pouvant être connectées ou déconnectées individuellement sous la commande du dispositif de mémorisation. Un interrupteur constitué par un transistor respectif T₁₁ à T₁ₙ est placé en série avec chaque capacité. La capacité Cₚ₁ peut prendre un ensemble de valeurs possibles selon la ou les capacités qui sont connectées à un moment donné. Les capacités individuelles peuvent correspondre chacune à un poids binaire respectif pour permettre d'obtenir facilement 2ⁿ valeurs avec n capacités. La capacité Cₚ₂ est constituée comme la capacité Cₚ₁.

## Revendications

1. Procédé d'adaptation d'impédance d'une chaîne d'émission ou de réception comprenant les étapes suivantes :
- connecter de manière amovible un premier module (M-P) contenant un amplificateur (AMP) à un deuxième module (M-C) contenant des moyens de calcul d'adaptation d'impédance ;
- connecter de manière amovible un troisième module (M-A) au deuxième module, alors que le deuxième module est connecté au premier, le troisième module contenant une antenne (ANT), un réseau d'impédances d'adaptation (MN), et des moyens de mémorisation (MEM) de données de commande du réseau d'impédances,
- effectuer un calcul d'adaptation dans le deuxième module pendant qu'il est ainsi connecté de manière amovible entre le premier et le troisième module, et fournir par le deuxième module au troisième module des données de commande du réseau d'impédances d'adaptation, résultant de ce calcul,
- mémoriser les données de commande dans les moyens de mémorisation du troisième module,
- enlever le deuxième module et connecter de manière amovible le troisième module au premier module de manière à relier l'amplificateur à l'antenne à travers le réseau d'impédances d'adaptation, ce dernier étant commandé par les données de commande mémorisées.

2. Chaîne d'émission ou de réception radiofréquence comportant au moins un amplificateur (AMP), une antenne (ANT) et un réseau d'impédances d'adaptation (MN) disposé entre l'amplificateur et l'antenne, chaîne **caractérisée en ce qu'**elle comprend un module d'amplification (M-P) et un module d'antenne, le module d'amplification contenant l'amplificateur et au moins un premier connecteur (K_{1P}) pour une connexion amovible au module d'antenne (M-A), le module d'antenne contenant l'antenne, le réseau d'impédances d'adaptation, au moins un premier connecteur (K_{1A}) coopérant avec le premier connecteur du module d'amplification pour transmettre des signaux radiofréquence du module d'amplification vers le module d'antenne, des moyens (MEM) de mémorisation permanente de données de commande permettant une commande des impédances du réseau pour donner à ces impédances des valeurs désirées, et au moins un deuxième connecteur (K_{3A}) permettant une connexion amovible avec l'extérieur du module d'antenne pour recevoir de l'extérieur des données de commande à mémoriser.

3. Chaîne d'émission selon la revendication 2, **caractérisée en ce que** le module d'amplification comporte un connecteur (K_{2P}) connecté de manière amovible à un connecteur (K_{2A}) du module d'antenne pour une alimentation électrique du module d'antenne par le module d'amplification.

4. Chaîne d'émission ou de réception radiofréquence selon la revendication 2, **caractérisée en ce qu'**elle comporte en outre un module de calcul d'adaptation d'impédance (M-C), interposé entre le module d'amplification et le module d'antenne, le module de calcul d'adaptation d'impédance comportant :
- un premier connecteur (K1 C) connecté de manière amovible au premier connecteur (K_{1P}) du module d'amplification pour la transmission de signaux radiofréquence du module d'amplification au module de calcul,
- un deuxième connecteur (K'_{1C}) connecté de manière amovible au premier connecteur (K_{1A}) du module d'antenne pour la transmission de signaux radiofréquence du module de calcul au module d'antenne,
- un troisième connecteur (K'_{3C}) connecté de manière amovible au deuxième connecteur (K_{3A}) du module d'antenne,
- des moyens (Cₐ, CM, DSP) pour calculer des valeurs d'impédances d'adaptation en fonction de l'impédance de l'antenne et pour fournir des données de commande correspondantes aux moyens de mémorisation (MEM) à travers le troisième connecteur du module de calcul et le deuxième connecteur (K_{3A}) du module d'antenne.

5. Chaîne d'émission selon la revendication 4, **caractérisée en ce que** le module d'amplification comporte un connecteur (K_{2P}) pour la connexion amovible à un connecteur (K_{2C}) du module de calcul pour fournir une alimentation électrique à ce dernier.

6. Chaîne d'émission selon la revendication 5, **caractérisée en ce que** le module de calcul comporte un connecteur (K'_{2C}) pour la connexion amovible à un connecteur (K_{2A}) du module d'antenne, pour fournir une alimentation électrique à ce dernier.

7. Chaîne d'émission selon la revendication 6, **caractérisée en ce que** le connecteur (K_{2A}) du module d'antenne pour l'alimentation électrique est connectable directement au connecteur (K_{2P}) du module d'amplification pour l'alimentation électrique, pour l'alimentation électrique directe du module d'antenne par le module d'amplification.

8. Chaîne d'émission selon l'une des revendications 2 à 7, **caractérisée en ce que** les moyens de mémorisation comportent une mémoire permanente électriquement reprogrammable.

9. Chaîne d'émission selon l'une des revendications 2 à 7, **caractérisée en ce que** les moyens de mémorisation comportent des commutateurs à actionnement magnétique et à maintien magnétique, ne nécessitant pas d'alimentation électrique pour leur fonctionnement.

## Patentansprüche

1. Verfahren zur Impedanzanpassung in einer Sende- oder Empfangskette, das die folgenden Schritte umfasst:
- lösbares Verbinden eines ersten Moduls (M-P), das einen Verstärker (AMP) enthält, mit einem zweiten Modul (M-C), das Mittel zum Berechnen einer Impedanzanpassung umfasst;
- lösbares Verbinden eines dritten Moduls (M-A) mit dem zweiten Modul, während das zweite Modul mit dem ersten verbunden ist, wobei das dritte Modul eine Antenne (ANT), ein Impedanzanpassungsnetzwerk (MN) und Mittel zum Speichern (MEM) von Steuerdaten des Impedanznetzwerks umfasst,
- Bewirken einer Anpassungsberechnung in dem zweiten Modul, während es so lösbar zwischen dem ersten und dem dritten Modul verbunden ist, und Liefern, durch das zweite Modul zum dritten Modul, von Daten zum Steuern des Impedanzanpassungsnetzwerks, die aus dieser Berechnung resultieren,
- Speichern der Steuerdaten in den Speichermitteln des dritten Moduls,
- Entfernen des zweiten Moduls und Verbinden des dritten Moduls lösbar mit dem ersten Modul, um den Verstärker mit der Antenne durch das Impedanzanpassungsnetzwerk zu verbinden, das mit den gespeicherten Steuerdaten gesteuert wird.

2. Funkfrequenzsende- oder -empfangskette, die mindestens einen Verstärker (AMP), eine Antenne (ANT) und ein zwischen dem Verstärker und der Antenne angeordnetes Impedanzanpassungsnetzwerk (MN) umfasst, wobei die Kette **dadurch gekennzeichnet ist, dass** sie Folgendes umfasst: ein Verstärkungsmodul (M-P) und ein Antennenmodul, wobei das Verstärkungsmodul den Verstärker und mindestens einen ersten Verbinder (K_{1P}) für eine lösbare Verbindung mit dem Antennenmodul (M-A) umfasst, wobei das Antennenmodul die Antenne umfasst, das Impedanzanpassungsnetzwerk, mindestens einen ersten Verbinder (K_{1A}), der mit dem ersten Verbinder des Verstärkungsmoduls zusammenwirkt, um Funkfrequenzsignale des Verstärkungsmoduls zu dem Antennenmodul zu übertragen, Mittel (MEM) zum permanenten Speichern von Steuerdaten, die eine Steuerung der Impedanzen des Netzes zulassen, um diesen Impedanzen die gewünschten Werte zu verleihen, und mindestens einen zweiten Verbinder (K_{3A}), der eine lösbare Verbindung mit dem Äußeren des Antennenmoduls zulässt, um von außen zu speichernde Steuerdaten zu erhalten.

3. Sendekette nach Anspruch 2, **dadurch gekennzeichnet, dass** das Verstärkungsmodul einen Verbinder (K_{2P}) umfasst, der lösbar mit einem Verbinder (K_{2A}) des Antennenmoduls zum Versorgen des Antennenmoduls mit Strom durch das Verstärkungsmodul verbunden ist.

4. Funkfrequenzsende- oder -empfangskette nach Anspruch 2, **dadurch gekennzeichnet, dass** sie ferner ein Impedanzanpassungsrechenmodul (M-C) umfasst, das zwischen dem Verstärkungsmodul und dem Antennenmodul geschaltet ist, wobei das Impedanzanpassungsrechenmodul umfasst:
- einen ersten Verbinder (K_{1C}), der lösbar mit dem ersten Verbinder (K_{1P}) des Verstärkungsmoduls verbunden ist, zum Übertragen von Funkfrequenzsignalen des Verstärkungsmoduls zu dem Rechenmodul,
- einen zweiten Verbinder (K'_{1C}), der lösbar mit dem ersten Verbinder (K_{1A}) des Antennenmoduls verbunden ist, zum Übertragen der Funkfrequenzsignale des Rechenmoduls zu dem Antennenmodul,
- einen dritten Verbinder (K'_{3C}), der lösbar mit dem zweiten Verbinder (K_{3A}) des Antennenmoduls verbunden ist,
- Mittel (Cₐ, CM, DSP) zum Berechnen der Anpassungsimpedanzwerte in Abhängigkeit von der Impedanz der Antenne und zum Liefern von entsprechenden Steuerdaten zu den Speichermitteln (MEM) durch den dritten Verbinder des Rechenmoduls und den zweiten Verbinder (K_{3A}) des Antennenmoduls.

5. Sendekette nach Anspruch 4, **dadurch gekennzeichnet, dass** das Verstärkungsmodul einen Verbinder (K_{2P}) zum lösbaren Verbinden mit einem Verbinder (K_{2C}) des Rechenmoduls zum Liefern einer Stromversorgung zu Letzterem umfasst.

6. Sendekette nach Anspruch 5, **dadurch gekennzeichnet, dass** das Rechenmodul einen Verbinder (K'_{2C}) zum lösbaren Verbinden mit einem Verbinder (K_{2A}) des Antennenmoduls umfasst, zum Liefern einer Stromversorgung zu Letzterem.

7. Sendekette nach Anspruch 6, **dadurch gekennzeichnet, dass** der Verbinder (K_{2A}) des Antennenmoduls zur Stromversorgung direkt mit dem Verbinder (K_{2P}) des Verstärkungsmoduls zur Stromversorgung, zur direkten Stromversorgung des Antennenmoduls durch das Verstärkungsmodul verbunden werden kann.

8. Sendekette nach einem der Ansprüche 2 bis 7, **dadurch gekennzeichnet, dass** die Speichermittel einen elektrisch umprogrammierbaren permanenten Speicher umfassen.

9. Sendekette nach einem der Ansprüche 2 bis 7, **dadurch gekennzeichnet, dass** die Speichermittel Schalter mit magnetischer Betätigung und mit magnetischer Halterung umfassen, die für ihre Funktion keine Stromversorgung benötigen.

## Claims

1. Impedance matching method, for a transmitting or receiving system, comprising the following steps:
- connecting, in a detachable manner, a first module (M-P) containing an amplifier (AMP) to a second module (M-C) containing impedance matching computation means ;
- connecting, in a detachable manner, a third module (M-A) to the second module, whilst the second module is connected to the first one, the third module containing an antenna (ANT), a matching impedances network (MN) and memory means (MEM) for storing control data of the impedances network,
- carrying out a matching computation in the second module whilst it is thus connected in a detachable manner between the first and third modules, and providing, by the second module to the third module, control data for the matching impedances network, resulting from this computation,
- storing the control data in the memory means of the third module,
- removing the second module and connecting, in a detachable manner, the third module to the first module in such a way as to connect the amplifier to the antenna through the matching impedances network, the latter being controlled by the stored control data.

2. Radiofrequency transmitting or receiving system comprising at least one amplifier (AMP), an antenna (ANT) and a matching impedances network (MN) disposed between the amplifier and the antenna, this system being **characterized in that** it comprises an amplification module (M-P) and an antenna module, the amplification module containing the amplifier and at least a first connector (K_{1P}) for a detachable connection to the antenna module (M-A), the antenna module containing the antenna, the matching impedances network, at least a first connector (K_{1A}) cooperating with the first connector of the amplification module for transmitting radiofrequency signals from the amplification module to the antenna module, memory means (MEM) for the permanent storage of control data allowing a control of the impedances of the network in order to give these impedances desired values, and at least a second connector (K_{3A}) allowing a detachable connection of the antenna module with the exterior in order to receive from the exterior control data to be stored.

3. Transmitting system according to claim 2, **characterized in that** the amplification module comprises a connector (K_{2P}) connected in a detachable manner to a connector (K_{2A}) of the antenna module for an electrical power supply of the antenna module by the amplification module.

4. Radiofrequency transmitting or receiving system according to claim 2, **characterized in that** it further comprises an impedance matching computation module (M-C), interposed between the amplification module and the antenna module, the impedance matching computation module comprising:
- a first connector (K_{1C}) connected in a detachable manner to the first connector (K_{1P}) of the amplification module for the transmission of radiofrequency signals from the amplification module to the computation module,
- a second connector (K'_{1C}) connected in a detachable manner to the first connector (K_{1A}) of the antenna module for the transmission of radiofrequency signals from the computation module to the antenna module,
- a third connector (K'_{3C}) connected in a detachable manner to the second connector (K_{3A}) of the antenna module,
- means (Cₐ, CM, DSP) for computing matching impedance values as a function of the impedance of the antenna and in order to provide corresponding control data to the memory means (MEM) through the third connector of the computation module and the second connector (K_{3A}) of the antenna module.

5. Transmitting system according to claim 4, **characterized in that** the amplification module comprises a connector (K_{2P}) for the detachable connection to a connector (K_{2C}) of the computation module in order to provide an electrical power supply to the latter.

6. Transmitting system according to claim 5, **characterized in that** the computation module comprises a connector (K'_{2C}) for the detachable connection to a connector (K_{2A}) of the antenna module in order to provide an electrical power supply to the latter.

7. Transmitting system according to claim 6, **characterized in that** the connector (K_{2A}) of the antenna module for the electrical power supply is directly connectable to the electrical power supply connector (K_{2P}) of the amplification module for the direct electrical power supply of the antenna module by the amplification module.

8. Transmitting system according to any of claims 2 to 7, **characterized in that** the memory means comprise an electrically erasable programmable read-only memory.

9. Transmitting system according to any of claims 2 to 7, **characterized in that** the memory means comprise magnetic actuating and magnetic holding switches, which do not require an electrical power supply for their operation.
